(19) **Europäisches Patentamt / European Patent Office / Office européen des brevets**

(11) **EP 4 550 671 B1**

(12) # EUROPEAN PATENT SPECIFICATION

(45) Date of publication and mention
of the grant of the patent:
**10.06.2026 Bulletin 2026/24**

(51) International Patent Classification (IPC):
**H03M 13/11** $^{(2006.01)}$ **H03M 13/37** $^{(2006.01)}$
**H03M 13/45** $^{(2006.01)}$

(21) Application number: **23207143.1**

(22) Date of filing: **31.10.2023**

(52) Cooperative Patent Classification (CPC):
**H03M 13/1111; H03M 13/3723; H03M 13/451; H03M 13/458;** H03M 13/1117

(54) **DECODING APPARATUS AND METHOD IN WIRELESS COMMUNICATION NETWORK**

DEKODIERUNGSVORRICHTUNG UND -VERFAHREN IN EINEM DRAHTLOSEN KOMMUNIKATIONSNETZ

APPAREIL ET PROCÉDÉ DE DÉCODAGE DANS UN RÉSEAU DE COMMUNICATION SANS FIL

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**07.05.2025 Bulletin 2025/19**

(73) Proprietor: **Nokia Solutions and Networks Oy 02610 Espoo (FI)**

(72) Inventor: **VIHRIÄLÄ, Jaakko Eino Ilmari Oulu (FI)**

(74) Representative: **Nokia EPO representatives Nokia Technologies Oy Karakaari 7 02610 Espoo (FI)**

(56) References cited:
**WO-A1-2020/088256**

- **SCHOLL STEFAN ET AL: "Advanced iterative channel coding schemes: When Shannon meets Moore", PROC., IEEE 9TH INTERNATIONAL SYMPOSIUM ON TURBO CODES AND ITERATIVE INFORMATION PROCESSINGS, ISTC 2016, 5 September 2016 (2016-09-05), pages 406 - 411, XP032981334, DOI: 10.1109/ISTC.2016.7593146**
- **NEDELJKO VARNICA ET AL: "Augmented Belief Propagation Decoding of Low-Density Parity Check Codes", IEEE TRANSACTIONS ON COMMUNICATIONS, IEEE SERVICE CENTER, PISCATAWAY, NJ. USA, vol. 55, no. 7, 1 July 2007 (2007-07-01), pages 1308 - 1317, XP011187493, ISSN: 0090-6778, DOI: 10.1109/TCOMM.2007.900611**
- **SAMSUNG: "Quasi-ML Decoding of Short Length LDPC Codes", vol. RAN WG1, no. Reno, Nevada, US; 20161114 - 20161118, 5 November 2016 (2016-11-05), XP051190448, Retrieved from the Internet <URL:http://www.3gpp.org/ftp/tsg_ran/WG1_RL1/TSGR1_87/Docs/> [retrieved on 20161105]**

**Description**

## TECHNICAL FIELD

The present disclosure relates generally to the field of wireless communications. In particular, the present disclosure relates to a decoding apparatus and method in a wireless communication network, as well as a corresponding computer program product.

## BACKGROUND

A parity check is an error-correction process that is used to facilitate the recovery of data transmitted over a wireless communication channel. One type of parity check codes is a Low-Density Parity-Check (LDPC) code characterized by a Parity Check Matrix (PCM) representing a binary matrix that defines the connections between check nodes and variable nodes. An LDPC encoder on a transmitting side uses an LDPC coding scheme to encode a source word into a codeword, while a LDPC decoder on a receiving side uses the same LDPC coding scheme to decode the received codeword. Input data for the LDPC decoder may be represented by bit-wise Log-Likelihood Ratios (LLRs) from a demodulator. The LLRs contain reliability information of each bit decision made by the demodulator. At the output, the LDPC decoder may also provide LLRs for each bit (also parity bits).

As a rule, a message passing decoding algorithm is used for LDPC codes. Additionally, a Cyclic Redundancy Check (CRC) may be performed on the output of the LDPC decoder for the purpose of error detection. However, the message passing decoding algorithm has poor performance for small and medium-block length codes (e.g., those codes having up to 500 information bits). Although this drawback can be overcome by increasing the number of iterations in the message passing decoding algorithm, the resulting gain (in terms of low Block Error Rate (BLER) targets) remains very small.

The following background art discloses specific decoding algorithms used for LDPC codes:

- S. Scholl et al.: "Advanced iterative channel coding schemes: When Shannon meets Moore", IEEE 9th International Symposium on Turbo Codes and Iterative Information Processing, ISTC 2016, 5th September 2016, pages 406-411, DOI:10.1109/ISTC.2016.7593146
- V. Nedeljko et al.: "Augmented Belief Propagation Decoding of Low-Density Parity Check Codes", IEEE Trans. Communications, vol. 55, no. 7, 1st July 2007, pages 1308-1317, ISSN: 0090-6778, DOI:10.1109/TCOMM.2007.900611
- WO 2020/088256 A1 (HUAWEI TECH CO LTD [CN]) 7th May 2020
- Samsung: "Quasi-ML Decoding of Short Length LDPC Codes", 3GPP Draft; R1-1612551_Quasi-ML Decoding of Short Length LDPC Codes_final, RAN WG1, 20161114-20161118, 5th November 2016, URL: http://www.3gpp.org/ftp/tsg_ran/ WG1_RL1/TSGR1_87/Docs/

## SUMMARY

This summary is provided to introduce a selection of concepts in a simplified form that are further described below in the detailed description. This summary is not intended to identify key features of the present disclosure, nor is it intended to be used to limit the scope of the present disclosure. It is an objective of the present disclosure to provide a technical solution that improves the decoding performance of bits encoded with a linear error-correcting block code (e.g., LDPC code or polar code) of small or medium block length (e.g., including up to 500 information bits).

The objective above is achieved by the features of the independent claims in the appended claims. Further embodiments and examples are apparent from the dependent claims, the detailed description, and the accompanying drawings.

According to a first aspect, a decoding apparatus in a wireless communication network is provided. The decoding apparatus comprises at least one processor and at least one memory storing instructions that, when executed by the at least one processor, cause the decoding apparatus to perform at least as follows. At first, the decoding apparatus receives a modulated signal comprising a set of bits encoded with a linear error-correcting block code. Each bit of the set of bits has a bit position. Then, the decoding apparatus obtains a set of demodulated LLRs for the set of bits by demodulating the modulated signal. After that, the decoding apparatus decodes the set of bits by using a multi-stage decoding algorithm based on the set of demodulated LLRs. The multi-stage decoding algorithm comprises an input decoding stage, a first intermediate decoding stage, a second intermediate decoding stage and an output decoding stage.

At the input decoding stage, the decoding apparatus is caused to: (i) obtain a set of decoded LLRs based on the set of demodulated LLRs; (ii) find a first subset of B bit positions each associated with a first smallest absolute LLR value based on the set of decoded LLRs, where B is a natural number; (iii) instead of the first smallest absolute LLR value, assign a maximum possible absolute LLR value to each bit position of the first subset of $B$ bit positions; and (iv) form first $2^B$ vectors of LLRs based on the set of demodulated LLRs, the set of decoded LLRs, and the first subset of B bit positions.

At the first intermediate decoding stage, the decoding apparatus is caused to: (v) decode each of the first $2^B$ vectors of LLRs in parallel, thereby obtaining an individual set of decoded LLRs for each of the first $2^B$ vectors of LLRs; (vi) obtain a first averaged set of decoded LLRs by averaging the individual sets of decoded LLRs obtained in operation (v); (vii) find a second subset of $B$ bit positions each associated with a second smallest absolute LLR value in the first averaged set of decoded LLRs, the second subset of $B$ bit positions and the first subset of $B$ bit positions being non-overlapping; (viii) instead of the second smallest absolute LLR value, assign the maximum possible absolute LLR value to each bit position of the second subset of $B$ bit positions; and (ix) form second $2^B$ vectors of LLRs based on the set of demodulated LLRs, the first averaged set of decoded LLRs and the second subset of $B$ bit positions.

At the second intermediate decoding stage, the decoding apparatus is caused to: (x) decode each of the second $2^B$ vectors of LLRs in parallel, thereby obtaining an individual set of decoded LLRs for each of the second $2^B$ vectors of LLRs; and (xi) obtain a second averaged set of decoded LLRs by averaging the individual sets of decoded LLRs obtained in operation (x).

Finally, at the output decoding stage, the decoding apparatus is caused to (xii) decode the set of bits based on the set of demodulated LLRs and the second averaged set of decoded LLRs.

The decoding apparatus thus configured may properly decode bits encoded, among others, with a linear error-correcting block code having a small or medium block length. This may make it possible to use the decoding apparatus in Ultra-Reliable Low Latency Communication (URLLC) and Machine-Type wireless Communication (MTC) applications where low BLERs are required, and packet sizes are smaller than in a mobile broadband.

In one example embodiment of the first aspect, the linear error-correcting block code is an LDPC code or a polar code, and the multi-stage decoding algorithm is an LDPC decoding algorithm or a polar code decoding algorithm, respectively. Polar and LDPC codes are two promising types of codes that may be efficiently used in 5G and next-generation communication systems. Therefore, the decoding apparatus configured to perform LDPC or polar decoding may be efficiently used in the upcoming next-generation communication systems.

In one example embodiment of the first aspect, the LDPC decoding algorithm is a min-sum LDPC decoding algorithm or a sum-product LDPC decoding algorithm. This may allow the decoding apparatus to be more flexible in use.

In one example embodiment of the first aspect, the decoding apparatus is further caused, in operation (ix), to calculate a weighted sum of the set of demodulated LLRs and the first averaged set of decoded LLRs and to form the second $2^B$ vectors of LLRs based on the weighted sum of the set of demodulated LLRs and the first averaged set of decoded LLRs. By doing so, it is possible to increase the BLER-related efficiency of the multi-stage decoding algorithm.

In one example embodiment of the first aspect, the linear error-correcting block code has a block length and a code rate, and the decoding apparatus is further caused to calculate the weighted sum of the set of demodulated LLRs and the first averaged set of decoded LLRs taking into account the block length and the code rate. By doing so, it is possible to perform said weighted-sum calculation more efficiently, thereby further improving the BLER-related efficiency of the multi-stage decoding algorithm.

In one example embodiment of the first aspect, the decoding apparatus is caused, in operations (i), (vi) and (x), to check whether there is at least one bit error in the set of decoded LLRs, the first averaged set of decoded LLRs and the second averaged set of decoded LLRs, respectively, by using a CRC technique. By doing so, it is possible to detect accidental changes or errors in the set of bits transmitted by using the modulated signal in the wireless communication network.

According to a second aspect, a decoding method in a wireless communication network is provided. The method starts with the step of receiving a modulated signal comprising a set of bits encoded with a linear error-correcting block code. Each bit of the set of bits has a bit position. Next, the method goes on to the step of obtaining a set of demodulated LLRs for the set of bits by demodulating the modulated signal. After that, the method proceeds to the step of decoding the set of bits by using a multi-stage decoding algorithm based on the set of demodulated LLRs. The multi-stage decoding algorithm comprises an input decoding stage, a first intermediate decoding stage, a second intermediate decoding stage and an output decoding stage.

The input decoding stage comprises: (i) obtaining a set of decoded LLRs based on the set of demodulated LLRs; (ii) finding a first subset of $B$ bit positions each associated with a first smallest absolute LLR value in the set of decoded LLRs, where $B$ is a natural number; (iii) instead of the first smallest absolute LLR value, assigning a maximum possible absolute LLR value to each bit position of the first subset of $B$ bit positions; and (iv) forming first $2^B$ vectors of LLRs based on the set of demodulated LLRs, the set of decoded LLRs, and the first subset of $B$ bit positions.

The first intermediate decoding stage comprises: (v) decoding each of the first $2^B$ vectors of LLRs in parallel, thereby obtaining an individual set of decoded LLRs for each of the first $2^B$ input vectors; (vi) obtaining a first averaged set of decoded LLRs by averaging the individual sets of decoded LLRs obtained in step (v); (vii) finding a second subset of $B$ bit positions each associated with a second smallest absolute LLR value in the first averaged set of decoded LLRs, the second subset of $B$ bit positions and the first subset of $B$ bit positions being non-overlapping; (viii) instead of the second smallest absolute LLR value, assigning the maximum possible absolute LLR value to each bit position of the second subset of $B$ bit positions; and (ix) forming second $2^B$ vectors of LLRs based on the set of demodulated LLRs, the first averaged set of decoded LLRs and the second subset of B bit positions.

The second intermediate decoding stage comprises: (x) decoding each of the second $2^B$ vectors of LLRs in parallel, thereby obtaining an individual set of decoded LLRs for each of the second $2^B$ vectors of LLRs; and (xi) obtaining a second averaged set of decoded LLRs by averaging the individual sets of decoded LLRs obtained in step (x).

Finally, the output decoding stage comprises (xii) decoding the set of bits based on the set of demodulated LLRs and the second averaged set of decoded LLRs.

By using the decoding method according to the second aspect, it is possible to properly decode bits encoded, among others, with a linear error-correcting block code having a small or medium block length. This may make it possible to use the decoding method in the URLLC and MTC applications where low BLERs are required, and packet sizes are smaller than in a mobile broadband.

In one example embodiment of the second aspect, the linear error-correcting block code is an LDPC code or a polar code, and the multi-stage decoding algorithm is an LDPC decoding algorithm or a polar code decoding algorithm, respectively. Polar and LDPC codes are two promising types of codes that may be efficiently used in 5G and next-generation communication systems. Therefore, the decoding method according to the second aspect may be efficiently used in the upcoming next-generation communication systems.

In one example embodiment of the second aspect, the LDPC decoding algorithm is a min-sum LDPC decoding algorithm or a sum-product LDPC decoding algorithm. This may allow the decoding method according to the second aspect to be more flexible in use.

In one example embodiment of the second aspect, step (ix) is performed by calculating a weighted sum of the set of demodulated LLRs and the first averaged set of decoded LLRs and forming the second $2^B$ vectors of LLRs based on the weighted sum of the set of demodulated LLRs and the first averaged set of decoded LLRs. By doing so, it is possible to increase the BLER-related efficiency of the multi-stage decoding algorithm.

In one example embodiment of the second aspect, the linear error-correcting block code has a block length and a code rate, and the weighted sum of the set of demodulated LLRs and the first averaged set of decoded LLRs is calculated taking into account the block length and the code rate. By doing so, it is possible to perform said weighted-sum calculation more efficiently, thereby further improving the BLER-related efficiency of the multi-stage decoding algorithm.

In one example embodiment of the second aspect, the decoding method further comprises, in each of steps (i), (vi) and (x), the sub-step of checking whether there is at least one bit error in the set of decoded LLRs, the first averaged set of decoded LLRs and the second averaged set of decoded LLRs, respectively, by using a CRC technique. By doing so, it is possible to detect accidental changes or errors in the set of bits transmitted by using the modulated signal in the wireless communication network.

According to a third aspect, a computer program product is provided. The computer program product comprises a computer-readable storage medium that stores a computer code. Being executed by at least one processor, the computer code causes the at least one processor to perform the method according to the second aspect. By using such a computer program product, it is possible to simplify the implementation of the method according to the second aspect in any decoding apparatus, like the decoding apparatus according to the first aspect.

Other features and advantages of the present disclosure will be apparent upon reading the following detailed description and reviewing the accompanying drawings.

**BRIEF DESCRIPTION OF THE DRAWINGS**

The present disclosure is explained below with reference to the accompanying drawings in which:

FIG. 1 shows a block diagram of an LDPC decoder in accordance with the prior art;

FIGs. 2A-2D schematically explain how the LDPC decoder of FIG. 1 may perform saturation with respect to the least reliable bit positions (i.e., those bit positions corresponding to the smallest absolute LLR value);

FIG. 3 shows a block diagram of a decoding apparatus in accordance with one example embodiment;

FIG. 4 shows a flowchart of a method for operating the apparatus of FIG. 3 in accordance with one example embodiment;

FIG. 5 shows a sub-step sequence of an input decoding stage of a multi-stage decoding algorithm used in the method of FIG. 4 in accordance with one example embodiment;

FIG. 6 shows a sub-step sequence of a first intermediate decoding stage of the multi-stage decoding algorithm used in the method of FIG. 4 in accordance with one example embodiment;

FIG. 7 shows a sub-step sequence of a second intermediate decoding stage of the multi-stage decoding algorithm used in the method of FIG. 4 in accordance with one example embodiment;

FIG. 8 shows a block diagram of a processor included in the apparatus of FIG. 3 in accordance with one example embodiment; and

FIGs. 9A and 9B show a BLER versus a Signal-to-Noise Ratio (SNR), as obtained by using a conventional decoding method and the method of FIG. 4 for two different LDPC codes, namely: the curves shown in FIG. 9A are obtained for the LDPC code having K = 44 information bits and a code rate of R = 1/3, while the curves shown in FIG. 9B are obtained for the LDPC code having K = 88 information bits and a code rate of R = 1/3.

## DETAILED DESCRIPTION

Various embodiments of the present disclosure are further described in more detail with reference to the accompanying drawings. However, the present disclosure can be embodied in many other forms and should not be construed as limited to any certain structure or function discussed in the following description. In contrast, these embodiments are provided to make the description of the present disclosure detailed and complete.

According to the detailed description, it will be apparent to the ones skilled in the art that the scope of the present disclosure encompasses any embodiment thereof, which is disclosed herein. For example, the apparatus and method disclosed herein can be implemented in practice by using any numbers of the embodiments provided herein. Furthermore, it should be understood that any embodiment of the present disclosure can be implemented using one or more of the elements presented in the appended claims.

Unless otherwise stated, any embodiment recited herein as "example embodiment" should not be construed as preferable or having an advantage over other embodiments.

According to the example embodiments disclosed herein, a User Equipment (UE) may refer to an electronic computing device that is configured to perform wireless communications. The UE may be implemented as a mobile station, a mobile terminal, a mobile subscriber unit, a mobile phone, a cellular phone, a smart phone, a cordless phone, a personal digital assistant (PDA), a wireless communication device, a desktop computer, a laptop computer, a tablet computer, a gaming device, a netbook, a smartbook, an ultrabook, a medical mobile device or equipment, a biometric sensor, a wearable device (e.g., a smart watch, smart glasses, a smart wrist band, etc.), an entertainment device (e.g., an audio player, a video player, etc.), a vehicular component or sensor (e.g., a driver-assistance system), a smart meter/sensor, an unmanned vehicle (e.g., an industrial robot, a quadcopter, etc.) and its component (e.g., a self-driving car computer), industrial manufacturing equipment, a global positioning system (GPS) device, an Internet-of-Things (IoT) device, an Industrial IoT (IIoT) device, a machine-type communication (MTC) device, a group of Massive IoT (MIoT) or Massive MTC (mMTC) devices/sensors, or any other suitable mobile device configured to support wireless communications. In some embodiments, the UE may refer to at least two collocated and inter-connected UEs thus defined.

As used in the example embodiments disclosed herein, a network node may refer to a fixed point of communication/communication node for a UE in a particular wireless communication network. More specifically, the network node may be used to connect the UE to a Data Network (DN) through a Core Network (CN) and may be referred to as a base transceiver station (BTS) in terms of the 2G communication technology, a NodeB in terms of the 3G communication technology, an evolved NodeB (eNodeB or eNB) in terms of the 4G communication technology, and a gNB or relay station (e.g., Integrated Access and Backhaul (IAB)) in terms of the 5G or 6G New Radio (NR) communication technology. The network node may serve different cells, such as a macrocell, a microcell, a picocell, a femtocell, and/or other types of cells. The macrocell may cover a relatively large geographic area (e.g., at least several kilometers in radius). The microcell may cover a geographic area less than two kilometers in radius, for example. The picocell may cover a relatively small geographic area, such, for example, as offices, shopping malls, train stations, stock exchanges, etc. The femtocell may cover an even smaller geographic area (e.g., a home). Correspondingly, the network node serving the macrocell may be referred to as a macro node, the network node serving the microcell may be referred to as a micro node, and so on.

According to the example embodiments disclosed herein, a wireless communication network, in which a UE and a network node communicate with each other, may refer to a cellular or mobile network, a Wireless Local Area Network (WLAN), a Wireless Personal Area Networks (WPAN), a Wireless Wide Area Network (WWAN), a satellite communication (SATCOM) system, or any other type of wireless communication networks. Each of these types of wireless communication networks supports wireless communications according to one or more communication protocol standards. For example, the cellular network may operate according to the Global System for Mobile Communications (GSM) standard, the Code-Division Multiple Access (CDMA) standard, the Wide-Band Code-Division Multiple Access (WCDM) standard, the Time-Division Multiple Access (TDMA) standard, or any other communication protocol standard, the WLAN may operate according to one or more versions of the IEEE 802.11 standards, the WPAN may operate according to the Infrared Data Association (IrDA), Wireless USB, Bluetooth, or ZigBee standard, and the WWAN may operate according to the Worldwide Interoperability for Microwave Access (WiMAX) standard.

Block codes, or error correcting codes, are frequently used to provide reliable transmission of data over noisy wireless communication channels. In a typical block code, an information message or sequence is split up into blocks, and an encoder at a transmitting device then mathematically adds redundancy to the information message. Exploitation of this redundancy in the encoded information message is the key to reliability of the message, enabling correction for any bit errors that may occur due to noise. That is, a decoder at a receiving device can take advantage of the redundancy to reliably recover the information message even though bit errors may occur, in part, due to the addition of noise to the wireless communication channel.

One example of such block codes is LDPC codes which are well-known to those skilled in the art. For future networks, such as 6G networks, the LDPC codes may continue to be implemented to support a wide range of information block lengths and a wide range of code rates.

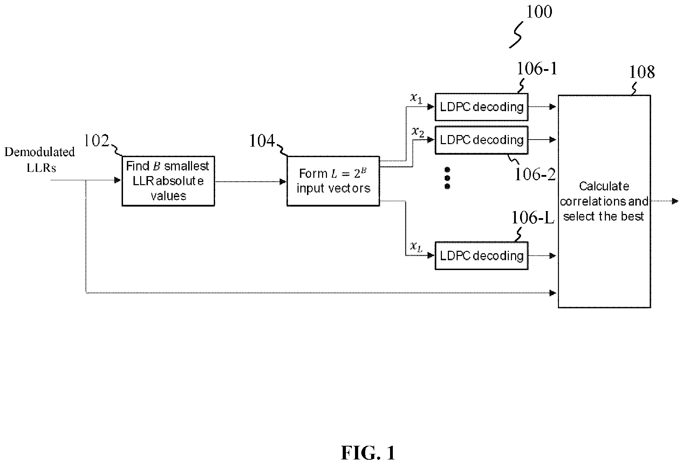

FIG. 1 shows a block diagram of an LDPC decoder 100 in accordance with the prior art. More specifically, the LDPC decoder 100 corresponds to the one disclosed in the following document: P. Schlaefer, S. Scholl, E. Leonardi, and N. Wehn, "A new LDPC decoder hardware implementation with improved error rates," in 2015 IEEE Jordan Conference on Applied Electrical Engineering and Computing Technologies (AEECT), 2015, pp. 1-6. The LDPC decoder 100 may be part of a receiver included in a UE or a network node and is configured to implement the so-called saturated decoding as follows.

Let us consider the transmission of $N$ code bits $\mathbf{x} = (x_0, x_1, ..., x_{N-1})$ over an Additive White Gaussian Noise (AWGN) channel using Binary Phase-Shift Keying (BPSK) and 64-Quadrature Amplitude Modulation (QAM) modulation. On the receiver side, the received code bits are described by a set of LLRs $\mathbf{y} = (y, y_1, ..., y_{N-1})$ obtained by means of demodulation, where

$$y_i = ln\left(\frac{p(x_i=0)}{p(x_i=1)}\right) \in \mathbb{R}$$ , where $p(x_i = 0)$ represents the probability that the i-th code bit of $\mathbf{x}$ is a binary value of 0, $p(x_i = 1)$ represents the probability that the i-th code bit of $\mathbf{x}$ is a binary value of 1, and $\mathbb{R}$ is the field of real numbers. The value $|y_i|$ can be considered as a measure of reliability of the received code bits. A small value $|y_i|$ corresponds to an unreliable bit that is more likely in error than others.

Referring to FIG. 1, the LDPC decoder 100 comprises a unit 102 which is configured to receive the set $\mathbf{y}$ of demodulated LLRs. As noted above, all LLRs are real numbers. The unit 102 is further configured to find $B$ smallest LLR values for saturation prior to starting the decoding process itself. This is done by sorting the values $|y_i|$ and selecting the smallest one among them. In other words, the unit 102 determines bit positions which correspond to the smallest absolute value $|y_i|$. After that, $L = 2^B$ input vectors of LLRs are generated in a next unit 104 of the LDPC decoder 100 by setting the least reliable bit positions to a maximum possible absolute LLR value, i.e., they are saturated. Next, for each of the $L$ input vectors of LLRs, a decoding run is executed in corresponding one of LDPC decoding units 106-1, 106-2, ..., 106-L which included in the LDPC decoder 100. Finally, the output data (codewords) of the LDPC decoding units 106-1, 106-2, ..., 106-L are compared in a unit 108 of the LDPC decoder 100 to find any correlation, and the best codeword is selected.

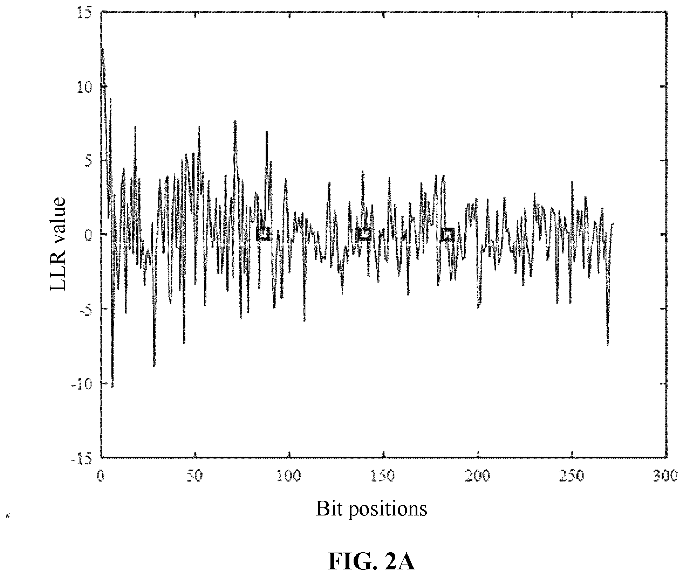

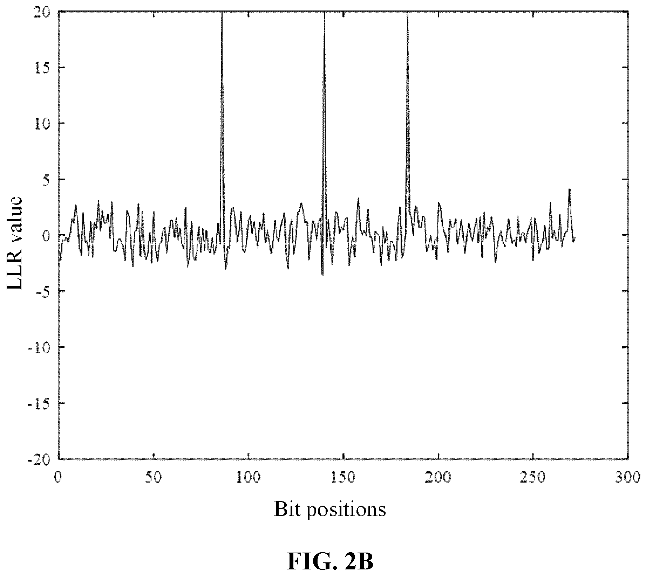

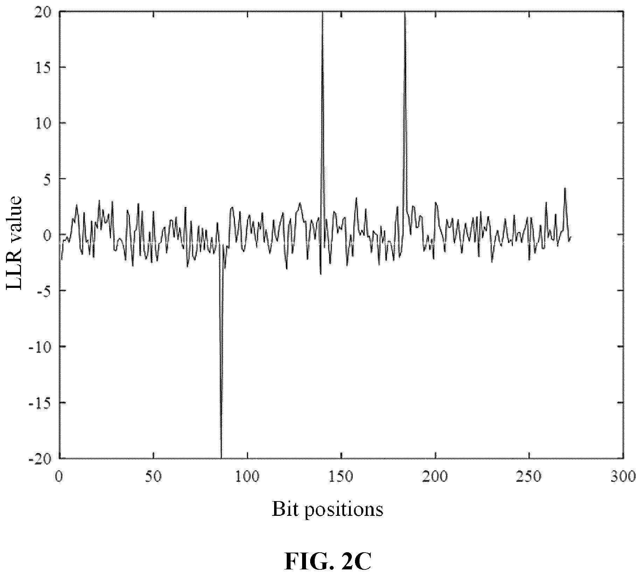

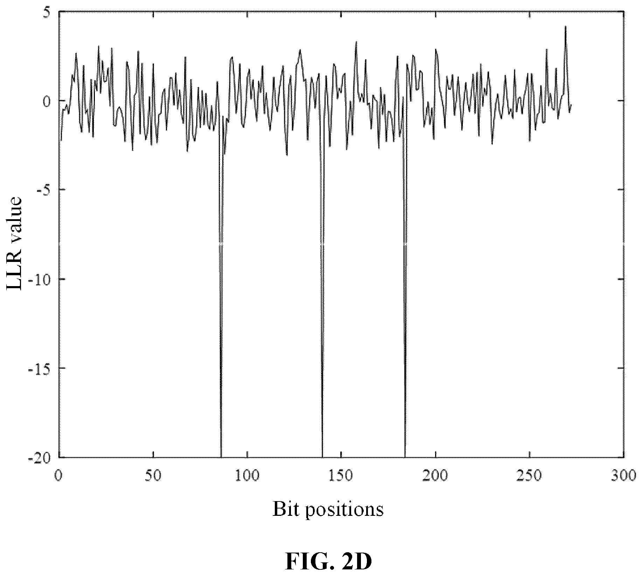

FIGs. 2A-2D schematically explain how the LDPC decoder 100 may perform the above-mentioned saturation with respect to the least reliable bit positions (i.e., those bit positions corresponding to the smallest absolute LLR value). In FIG. 2A, it is assumed that the set $\mathbf{y}$ of demodulated LLRs comprises three bit positions corresponding to the smallest LLR value, i.e., $B = 3$ (these three bit positions are shown as black squares in FIG. 2A). Each of the three bit positions should be assigned a maximum possible absolute LLR value, i.e., plus infinity (+inf) and minus infinity (-inf) in the ideal case. In practice, these infinity values can, of course, be replaced by the LLR values that are big/small enough compared to the other LLR values (e.g., such big/small LLR values may be defined based on capabilities of the LDPC decoder 100). Given this, one can obtain $L = 2^3 = 8$ different sets $\mathbf{y}$ of demodulated LLRs, in each of which there are three saturated bit positions. For example, FIG. 2B relates to the set $\mathbf{y}$ of demodulated LLRs, in which the three bit positions are all saturated by assigning each of them a maximum positive LLR value. FIG. 2C relates to the set $\mathbf{y}$ of demodulated LLRs, in which two of the bit positions are saturated by assigning them the maximum positive LLR value and one of the bit positions is saturated by assigning it a maximum negative LLR value. FIG. 2D relates to the set $\mathbf{y}$ of demodulated LLRs, in which the three bit positions are all saturated by assigning each of them the maximum negative LLR value. Those skilled in the art would recognize how to obtain the rest of said 8 different sets y of demodulated LLRs. Each of said 8 different sets $\mathbf{y}$ of demodulated LLRs is processed by corresponding one of the LDPC decoding units 106-1, 106-2, ..., 106-L. In other words, the LDPC decoding unit 106-1 processes the set $\mathbf{y}$ of demodulated LLRs which is shown in FIG. 2B, the LDPC decoding unit 106-2 processes the set $\mathbf{y}$ of demodulated LLRs which is shown in FIG. 2C, and so on - the last LDPC decoding unit 106-L process the set $\mathbf{y}$ of demodulated LLRs which is shown in FIG. 2D.

The above-described operation of the LDPC decoder 100 improves the probability of correct decoding but at the cost of increased complexity.

The example embodiments disclosed herein provide a technical solution that allows mitigating or even eliminating the above-sounded drawbacks peculiar to the prior art. In particular, the technical solution disclosed herein improves the decoding performance of bits encoded with a linear error-correcting block code (e.g., LDPC code or polar code) of small or medium block length (i.e., up to 500 information bits). For this purpose, a multi-stage decoding algorithm is used, which comprises an input decoding stage, at least two intermediate decoding stages and an output decoding stage. For each of the decoding stages (except for the last intermediate decoding stage and the output decoding stage), a certain number of bit positions is selected and set to a maximum possible absolute LLR value. The output data of each decoding stage is used to compute the input data of the next decoding stage. Each of the intermediate decoding stages executes a specified number of parallel decoding runs, and the input data for each of the intermediate decoding stages may be generated based on the output data of the previous intermediate decoding stage and initial LLRs obtained after demodulation. The bit positions set to the maximum possible absolute LLR value in the previous decoding stage cannot be used again in the next decoding stage. At the output decoding stage, only one decoding run is executed, for which input data are formed based on the initial LLRs and the LLRs obtained at the last intermediate decoding stage.

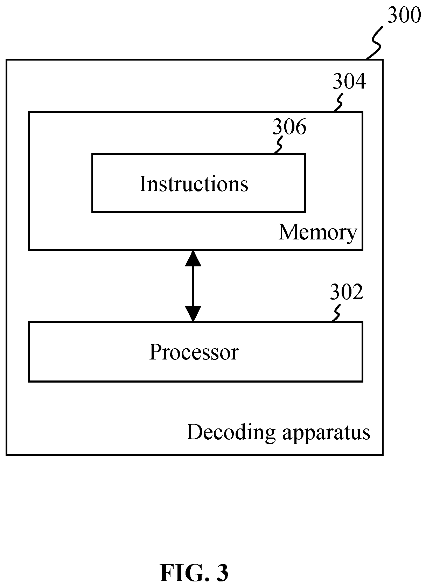

FIG. 3 shows a block diagram of a decoding apparatus 300 in accordance with one example embodiment. The decoding apparatus 300 is intended to be part of a receiver included in a UE or a network node in a wireless communication network. As shown in FIG. 3, the decoding apparatus 300 comprises a processor 302 and a memory 304. The memory 304 stores processor-executable instructions 306 which, when executed by the processor 302, cause the processor 302 to perform the aspects of the present disclosure, as will be described below in more detail. It should be noted that the number, arrangement, and interconnection of the constructive elements constituting the decoding apparatus 300, which are shown in FIG. 3, are not intended to be any limitation of the present disclosure, but merely used to provide a general idea of how the constructive elements may be implemented within the decoding apparatus 300. For example, the processor 302 may be replaced with several processors, as well as the memory 304 may be replaced with several removable and/or fixed storage devices, depending on particular applications. Furthermore, it is assumed that the processor 302 is capable of performing different operations required to perform data reception and transmission, such, for example, as signal modulation/demodulation, encoding/decoding, etc.

The processor 302 may be implemented as a CPU, general-purpose processor, single-purpose processor, microcontroller, microprocessor, application specific integrated circuit (ASIC), field programmable gate array (FPGA), digital signal processor (DSP), complex programmable logic device, etc. It should be also noted that the processor 302 may be implemented as any combination of one or more of the aforesaid. As an example, the processor 302 may be a combination of two or more microprocessors.

The memory 304 may be implemented as a classical nonvolatile or volatile memory used in the modern electronic computing machines. As an example, the nonvolatile memory may include Read-Only Memory (ROM), ferroelectric Random-Access Memory (RAM), Programmable ROM (PROM), Electrically Erasable PROM (EEPROM), solid state drive (SSD), flash memory, magnetic disk storage (such as hard drives and magnetic tapes), optical disc storage (such as CD, DVD and Blu-ray discs), etc. As for the volatile memory, examples thereof include Dynamic RAM, Synchronous DRAM (SDRAM), Double Data Rate SDRAM (DDR SDRAM), Static RAM, etc.

The processor-executable instructions 306 stored in the memory 304 may be configured as a computer-executable program code which causes the processor 302 to perform the aspects of the present disclosure. The computer-executable program code for carrying out operations or steps for the aspects of the present disclosure may be written in any combination of one or more programming languages, such as Java, C++, or the like. In some examples, the computer-executable program code may be in the form of a high-level language or in a pre-compiled form and be generated by an interpreter (also pre-stored in the memory 304) on the fly.

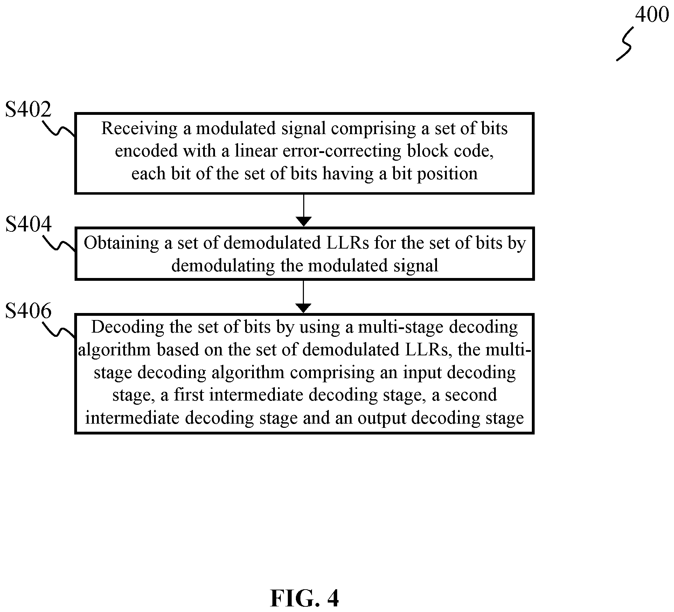

FIG. 4 shows a flowchart of a method 400 for operating the decoding apparatus 300 in accordance with one example embodiment. The method 400 starts with a step S402, in which the processor 302 receives a modulated signal comprising a set of bits encoded with a linear error-correcting block code (e.g., LDPC code or polar code). Each bit of the set of bits has a bit position. Next, the method 400 goes on to a step S404, in which the processor 302 obtains a set of demodulated LLRs for the set of bits by demodulating the modulated signal. After that, the method 400 proceeds to a step S406, in which the processor 302 decodes the set of bits by using a multi-stage decoding algorithm based on the set of demodulated LLRs. The multi-stage decoding algorithm comprises an input decoding stage, a first intermediate decoding stage, a second intermediate decoding stage and an output decoding stage. It should be noted that the number of intermediate decoding stages may be more than two, if required and depending on particular applications. For example, the number of the intermediate decoding stages may depend on a code rate, a number of information bits per a code block, etc. Each of the decoding stages of the multi-stage decoding algorithm will be now described in more detail with reference to the figures.

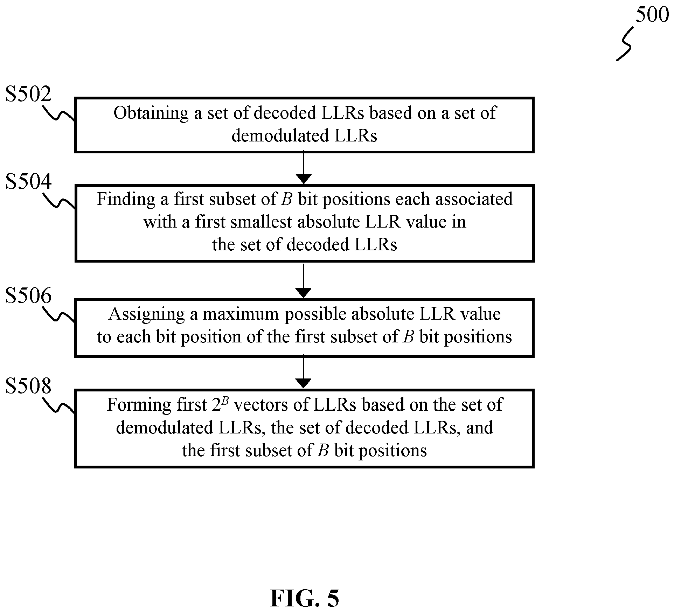

FIG. 5 shows a sub-step sequence 500 of the input decoding stage of the multi-stage decoding algorithm used in the method 400 in accordance with one example embodiment. As shown, the sub-step sequence 500 comprises sub-steps 5502-5508. In the sub-step S502, the processor 302 obtains a set of decoded LLRs based on the set of demodulated LLRs. In the sub-step S504, the processor 302 finds a first subset of $B$ bit positions each associated with a first smallest absolute LLR value in the set of decoded LLRs, where $B$ is a natural number. In the sub-step S506, the processor 302 assigns a maximum possible absolute LLR value to each bit position of the first subset of B bit positions, i.e., the processor 302 performs the above-described saturation. In the sub-step S508, the processor 302 forms first $2^B$ vectors of LLRs based on the set of demodulated LLRs, the set of decoded LLRs, and the first subset of $B$ bit positions. The processor 202 may perform said saturation and form the first $2^B$ vectors of LLRs in the same or similar manner as discussed above with references to FIGs. 2A-2D. The maximum possible absolute LLR value used in the sub-step S506 refers to a value $|LLR|$ such that $-LLR \ll y_i \ll +LLR$, where $y_i$ is the i-th LLR value from the set of decoded LLRs obtained in the sub-step S502.

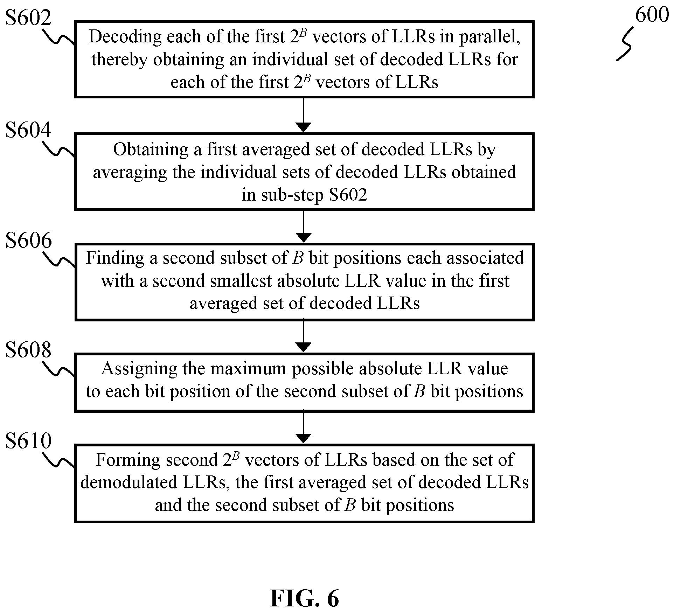

FIG. 6 shows a sub-step sequence 600 of the first intermediate decoding stage of the multi-stage decoding algorithm used in the method 400 in accordance with one example embodiment. As shown, the sub-step sequence 600 comprises sub-steps S602-S610. In the sub-step S602, the processor 202 initiates a decoding run for each of the first $2^B$ vectors of LLRs in parallel, thereby obtaining an individual set of decoded LLRs for each of the first $2^B$ vectors of LLRs. In the sub-step S604, the processor 302 obtains a first averaged set of decoded LLRs by averaging the individual sets of decoded LLRs obtained in the sub-step S602. In the sub-step S606, the processor 302 finds a second subset of $B$ bit positions in the first averaged set of decoded LLRs. The second subset of $B$ bit positions found by the processor 302 in the sub-step S606 does not overlap with the first subset of $B$ bit positions found by the processor 302 in the sub-step S504 during the input decoding stage. In the sub-step S608, the processor 302 assigns the maximum possible absolute LLR value to each bit position of the second subset of $B$ bit positions. In this case, the same maximum possible absolute LLR value is used as the one in the sub-step S506, i.e., $-LLR \ll y_i \ll +LLR$, but $y_i$ is now the i-th LLR value from the first averaged set of decoded LLRs obtained in the sub-step S604. In the sub-step S610, the processor 302 forms second $2^B$ vectors of LLRs based on the set of demodulated LLRs, the first averaged set of decoded LLRs and the second subset of bit positions. Again, the sub-steps S608 and S610 may be performed in the same or similar manner as discussed above with reference to FIGs. 2A-2D. In one embodiment, the processor 302 may use the weighted sum of the set of demodulated LLRs and the first averaged set of decoded LLRs in the sub-step S610 (for example, said weighted sum may be calculated taking into account the block length and code rate of the linear error-correcting block code).

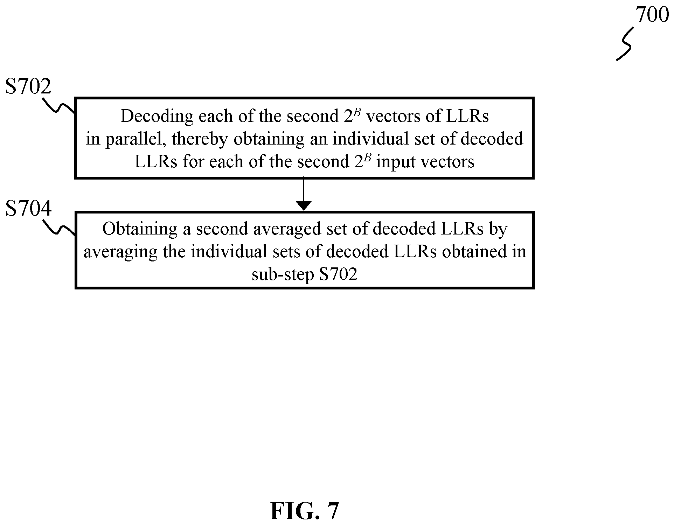

FIG. 7 shows a sub-step sequence 700 of the second intermediate decoding stage of the multi-stage decoding algorithm used in the method 400 in accordance with one example embodiment. As shown, the sub-step sequence 700 comprises sub-steps S702 and S704. In the sub-step S702, the processor 302 decodes each of the second $2^B$ vectors of LLRs in parallel, thereby obtaining an individual set of decoded LLRs for each of the second $2^B$ vectors of LLRs. In the sub-step S704, the processor 302 obtains a second averaged set of decoded LLRs by averaging the individual sets of decoded LLRs obtained in the sub-step S702.

The output decoding stage of the multi-stage decoding algorithm implies that the processor 302 decodes the set of bits based on the set of demodulated LLRs and the second averaged set of decoded LLRs.

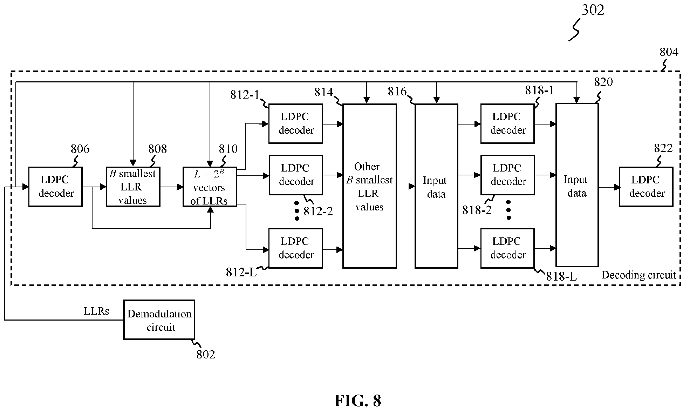

FIG. 8 shows a block diagram of the processor 302 included in the decoding apparatus 300 in accordance with one example embodiment. More specifically, in the embodiment shown in FIG. 8, the processor 302 is assumed to perform LDPC decoding. The processor 302 comprises a demodulation circuit 802 and a decoding circuit 804. The demodulation circuit 802 is configured to receive a modulated signal carrying a set of bits encoded with an LDPC code and demodulate it to obtain soft bit decisions in the form of LLRs which are real numbers. These LLRs obtained after demodulation are herein referred to as demodulated LLRs. The demodulated LLRs are then fed to the decoding circuit 804.

In the decoding circuit 804, an LDPC decoder 806 receives the demodulated LLRs and uses them to obtain decoded LLRs. The decoded LLRs are then fed to a unit 808 together with the demodulated LLRs. The unit 808 is configured to use both types of LLRs to find those B bit positions which should be set to the maximum possible absolute LLR value (i.e., saturated) in the same or similar manner as discussed above with reference to FIGs. 2A-2D. Once, the B bit positions are found and saturated, they are provided to a unit 810 together with the demodulated LLRs and the decoded LLRs. The unit 810 is configured to form the first $2^B$ vectors of LLRs, as indicated above. It should be noted that the joint operation of the LDPC decoder 806 and the units 808, 810 implements the input decoding stage of the multi-stage decoding algorithm.

The first $2^B$ vectors of LLRs are then processed by LDPC decoders 812-1, 812-2, ..., 812-L, respectively. The output data of the LDPC decoders 812-1, 812-2, ..., 812-L (i.e., the individual sets of decoded LLRs for the first $2^B$ vectors of LLRs) are then averaged by a unit 814 to obtain the first averaged set of decoded LLRs and find other $B$ bit positions to be saturated. Said "other $B$ bit positions" refer to those bit positions which have not been used at the input decoding stage. The other $B$ bit positions and the demodulated LLRs are further fed to a next unit 816. It should be noted that the joint operation of the LDPC decoders 812-1, 812-2, ..., 812-L and the units 814, 816 implements the first intermediate decoding stage of the multi-stage decoding algorithm. The unit 816 uses the received data to form the input data for the second intermediate decoding stage (i.e., the second $2^B$ vectors of LLRs).

The second intermediate decoding stage is implemented by the joint operation of LDPC decoders 818-1, 818-2, ..., 818-L and a unit 820. More specifically, each of the LDPC decoders 818-1, 818-2, ..., 818-L receives one of the second $2^B$ vectors of LLRs from the unit 816 and uses it to obtain an individual set of decoded LLRs for that $2^B$ vector of LLRs. The unit 820 averages the individual sets of decoded LLRs to obtain the second averaged set of decoded LLRs.

The output decoding stage of the multi-stage decoding algorithm is implemented by the operation of an LDPC decoder 822 that uses the set of demodulated LLRs and the second averaged set of decoded LLRs from the unit 820 to finally decode the set of bits.

It should be noted that, depending on the parameters (e.g., coding rate, code block length, etc.) of the code by which the initial set of bits has been encoded, there may be more than two intermediate decoding stages performed on the receiving side. With reference to FIG. 8, there may be an additional intermediate decoding stage between the first intermediate decoding stage (implemented by the joint operation of the LDPC decoders 812-1, 812-2, ..., 812-L and the units 814, 816) and the second intermediate decoding stage (implemented by the joint operation of LDPC decoders 818-1, 818-2, ..., 818-L and a unit 820). Said additional intermediate decoding stage may be similar to the first intermediate decoding stage in design and functionality, i.e., may use the output of the unit 816 as input data to obtain an additional averaged set of decoded LLRs based on the second $2^B$ vectors of LLRs and find an additional subset of $B$ bit positions therein (which does not overlap with the first and second subsets of $B$ bit positions). Then, said additional intermediate decoding stage may form third $2^B$ vectors of LLRs for the second intermediate decoding stage based on the set of demodulated LLRs, the additional averaged set of decoded LLRs and the additional subset of $B$ bit positions. Further, the second intermediate decoding stage may use the third $2^B$ vectors of LLRs to properly form the input data for the output decoding stage.

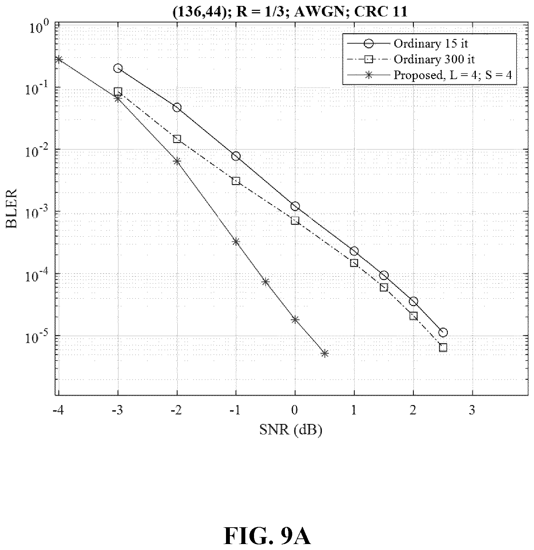

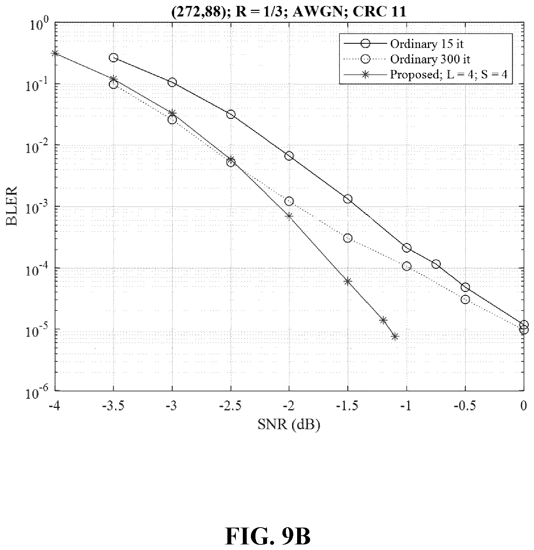

FIGs. 9A and 9B show a BLER versus a Signal-to-Noise Ratio (SNR), as obtained by using a conventional decoding method and the method 400 for two different LDPC codes. More specifically, the curves shown in FIG. 9A are obtained for the LDPC code having K = 44 information bits and a code rate of R = 1/3, while the curves shown in FIG. 9B are obtained for the LDPC code having K = 88 information bits and a code rate of R = 1/3. The conventional (or ordinary) decoding method refers to the one performed by the LDPC decoder 100 but without using the saturation approach proposed by P. Schlaefer, et. al., in the above-cited document. In FIG. 9A, the solid curves with circular points are obtained by using 15 iterations in the conventional decoding method, the dash-dotted curves with square points are obtained by using 300 iterations in the conventional decoding method, and the solid curves with asterisks are obtained by using L = 4 vectors of LLRs and four intermediate stages (each with max 15 iterations) in the method 400. In FIG. 9B, the solid curves with circular points are obtained by using 15 iterations in the conventional decoding method, the dotted curves with circular points are obtained by using 300 iterations in the conventional decoding method, and the solid curves with asterisks are obtained by using $L$ = 4 vectors of LLRs and four intermediate stages (each with max 15 iterations) in the method 400. As follows from FIG. 9A, the method 400 has a gain of 2.3 dB at BLER = $10^{-5}$. The gain provided by the method 400 is also clearly visible in FIG. 9B.

It should be noted that each step or operation of the method 400 and the sub-step sequences 500-700, or any combinations of the steps or operations, can be implemented by various means, such as hardware, firmware, and/or software. As an example, one or more of the steps or operations described above can be embodied by processor executable instructions, data structures, program modules, and other suitable data representations. Furthermore, the processor-executable instructions which embody the steps or operations described above can be stored on a corresponding data carrier and executed by the processor 302. This data carrier can be implemented as any computer-readable storage medium configured to be readable by said at least one processor to execute the processor executable instructions. Such computer-readable storage media can include both volatile and nonvolatile media, removable and non-removable media. By way of example, and not limitation, the computer-readable media comprise media implemented in any method or technology suitable for storing information. In more detail, the practical examples of the computer-readable media include, but are not limited to information-delivery media, RAM, ROM, EEPROM, flash memory or other memory technology, CD-ROM, digital versatile discs (DVD), holographic media or other optical disc storage, magnetic tape, magnetic cassettes, magnetic disk storage, and other magnetic storage devices.

Although the example embodiments of the present disclosure are described herein, it should be noted that various changes and modifications could be made in the embodiments of the present disclosure, with the scope of legal protection being defined by the appended claims. In the appended claims, the word "comprising" does not exclude other elements or operations, and the indefinite article "a" or "an" does not exclude a plurality. The mere fact that certain measures are recited in mutually different dependent claims does not indicate that a combination of these measures cannot be used to advantage.

**Claims**

1. A decoding apparatus (300) in a wireless communication network, comprising:

    at least one processor (302); and
    at least one memory (304) storing instructions (306) that, when executed by the at least one processor, cause the decoding apparatus at least to:

    receive (S402) a modulated signal comprising a set of bits encoded with a linear error-correcting block code, each bit of the set of bits having a bit position;

obtain (S404) a set of demodulated Log Likelihood Ratios, LLRs, for the set of bits by demodulating the modulated signal; and decode (S406) the set of bits by using a multi-stage decoding algorithm comprising an input decoding stage, a first intermediate decoding stage, a second intermediate decoding stage and an output decoding stage; wherein the decoding apparatus is caused, at the input decoding stage, to: i) obtain (S502) a set of decoded LLRs based on the set of demodulated LLRs; ii) find (S504) a first subset of $B$ bit positions each associated with a first smallest absolute LLR value in the set of decoded LLRs, where $B$ is a natural number; iii) instead of the first smallest absolute LLR value, assign (S506) a maximum possible absolute LLR value to each bit position of the first subset of $B$ bit positions; and iv) form (S508) first $2^B$ vectors of LLRs based on the set of demodulated LLRs, the set of decoded LLRs and the first subset of $B$ bit positions;

wherein the decoding apparatus is caused, at the first intermediate decoding stage, to: v) decode (S602) each of the first $2^B$ vectors of LLRs in parallel, thereby obtaining an individual set of decoded LLRs for each of the first $2^B$ vectors of LLRs; vi) obtain (S604) a first averaged set of decoded LLRs by averaging the individual sets of decoded LLRs obtained in operation v); vii) find (S606) a second subset of $B$ bit positions each associated with a second smallest absolute LLR value in the first averaged set of decoded LLRs, the second subset of $B$ bit positions and the first subset $of B$ bit positions being non-overlapping; viii) instead of the second smallest absolute LLR value, assign (S608) the maximum possible absolute LLR value to each bit position of the second subset of $B$ bit positions; ix) form (S610) second $2^B$ vectors of LLRs based on the set of demodulated LLRs, the first averaged set of decoded LLRs and the second subset of $B$ bit positions;

wherein the decoding apparatus is caused, at the second intermediate decoding stage, to: x) decode (S702) each of the second $2^B$ vectors of LLRs in parallel, thereby obtaining an individual set of decoded LLRs for each of the second $2^B$ vectors of LLRs; and xi) obtain (S704) a second averaged set of decoded LLRs by averaging the individual sets of decoded LLRs obtained in operation x); and

wherein the decoding apparatus is caused, at the output decoding stage, to xii) decode the set of bits based on the set of demodulated LLRs and the second averaged set of decoded LLRs.

2. The decoding apparatus of claim 1, wherein the linear error-correcting block code is a Low-Density Parity-Check, LDPC, code or a polar code, and wherein the multi-stage decoding algorithm is an LDPC decoding algorithm or a polar code decoding algorithm, respectively.

3. The decoding apparatus of claim 2, wherein the LDPC decoding algorithm is a min-sum LDPC decoding algorithm or a sum-product LDPC decoding algorithm.

4. The decoding apparatus of any one of claims 1 to 3, wherein the decoding apparatus is further caused, in operation ix), to calculate a weighted sum of the set of demodulated LLRs and the first averaged set of decoded LLRs, and to form the second $2^B$ vectors of LLRs based on the weighted sum of the set of demodulated LLRs and the first averaged set of decoded LLRs.

5. The decoding apparatus of claim 4, wherein the linear error-correcting block code has a block length and a code rate, and wherein the decoding apparatus is further caused to calculate the weighted sum of the set of demodulated LLRs and the first averaged set of decoded LLRs based on the block length and the code rate.

6. The decoding apparatus of any one of claims 1 to 5, wherein the decoding apparatus is further caused, in operations i), vi) and x) to check whether there is at least one bit error in the set of decoded LLRs, the first averaged set of decoded LLRs and the second averaged set of decoded LLRs, respectively, by using a Cyclic Redundancy Check, CRC, technique.

7. A decoding method in a wireless communication network, comprising:

receiving (S402) a modulated signal comprising a set of bits encoded with a linear error-correcting block code, each bit of the set of bits having a bit position;
obtaining (S404) a set of demodulated Log Likelihood Ratios, LLRs, for the set of bits by demodulating the modulated signal; and
decoding (S406) the set of bits by using a multi-stage decoding algorithm comprising an input decoding stage, a first intermediate decoding stage, a second intermediate decoding stage and an output decoding stage;

wherein the input decoding stage comprises: i) obtaining (S502) a set of decoded LLRs based on the set of demodulated LLRs; ii) finding (S504) a first subset of $B$ bit positions each associated with a first smallest absolute LLR value in the set of decoded LLRs, where $B$ is a natural number; iii) instead of the first smallest absolute LLR value, assigning (S506) a maximum possible absolute LLR value to each bit position of the first subset of $B$ bit positions; and iv) forming (S508) first $2^B$ vectors of LLRs based on the set of demodulated LLRs, the set of decoded LLRs and the first subset of B bit positions;

wherein the first intermediate decoding stage comprises: v) decoding (S602) each of the first $2^B$ vectors of LLRs in parallel, thereby obtaining an individual set of decoded LLRs for each of the first $2^B$ vectors of LLRs; vi) obtaining (S604) a first averaged set of decoded LLRs by averaging the individual sets of decoded LLRs obtained in step v); vii) finding (S606) a second subset of $B$ bit positions each associated with a second smallest absolute LLR value in the first averaged set of decoded LLRs, the second subset of $B$ bit positions and the first subset of $B$ bit positions being non-overlapping; viii) instead of the second smallest absolute LLR value, assigning (S608) the maximum possible absolute LLR value to each bit position of the second subset of $B$ bit positions; ix) forming (S610) second $2^B$ vectors of LLRs based on the set of demodulated LLRs, the first averaged set of decoded LLRs and the second subset of $B$ bit positions;

wherein the second decoding stage comprises: x) decoding (S702) each of the second $2^B$ vectors of LLRs in parallel, thereby obtaining an individual set of decoded LLRs for each of the second $2^B$ vectors of LLRs; and xi) obtaining (S704) a second averaged set of decoded LLRs by averaging the individual sets of decoded LLRs obtained in step x); and

wherein the output decoding stage comprises xii) decoding the set of bits based on the set of demodulated LLRs and the second averaged set of decoded LLRs.

8. The method of claim 7, wherein the linear error-correcting block code is a Low-Density Parity-Check, LDPC, code or a polar code, and wherein the multi-stage decoding algorithm is an LDPC decoding algorithm or a polar code decoding algorithm, respectively.

9. The method of claim 8, wherein the LDPC decoding algorithm is a min-sum LDPC decoding algorithm or a sum-product LDPC decoding algorithm.

10. The method of any one of claims 7 to 9, wherein step ix) is performed by calculating a weighted sum of the set of demodulated LLRs and the first averaged set of decoded LLRs and forming the second $2^B$ vectors of LLRs based on the weighted sum of the set of demodulated LLRs and the first averaged set of decoded LLRs.

11. The method of claim 10, wherein the linear error-correcting block code has a block length and a code rate, and wherein the weighted sum of the set of demodulated LLRs and the first averaged set of decoded LLRs is calculated based on the block length and the code rate.

12. The method of any one of claims 7 to 11, further comprising, in steps i), vi) and x) checking whether there is at least one bit error in the set of decoded LLRs, the first averaged set of decoded LLRs and the second averaged set of decoded LLRs, respectively, by using a Cyclic Redundancy Check, CRC, technique.

13. A computer-readable storage medium comprising a computer program product, wherein the computer-readable storage medium stores instructions which, when executed by at least one processor, causes the at least one processor to perform the method according to any one of claims 7 to 12.

**Patentansprüche**

1. Decodierungsvorrichtung (300) in einem drahtlosen Kommunikationsnetz, umfassend:

mindestens einen Prozessor (302); und mindestens einen Speicher (304), der Anweisungen (306) speichert, die, wenn sie von dem mindestens einen Prozessor ausgeführt werden, die Decodierungsvorrichtung veranlassen, mindestens Folgendes auszuführen:

Empfangen (S402) eines modulierten Signals, das einen Satz von Bits umfasst, der mit einem linearen fehlerkorrigierenden Blockcode codiert ist, wobei jedes Bit des Satzes von Bits eine Bitposition aufweist; Erhalten (S404) eines Satzes von demodulierten Log-Likelihood-Verhältnissen, LLRs, für den Satz von Bits durch Demodulation des modulierten Signals; und Decodieren (S406) des Satzes von Bits unter Verwendung eines mehrstufigen Decodierungsalgorithmus, der eine Eingangsdecodierungsstufe, eine erste Zwischendecodierungsstufe, eine zweite Zwischendecodierungsstufe und eine Ausgangsdecodierungsstufe umfasst;

wobei die Decodierungsvorrichtung veranlasst wird, in der Eingangsdecodierungsstufe:

i) einen Satz von decodierten LLRs auf der Grundlage des Satzes von demodulierten LLRs zu erhalten (S502);
ii) eine erste Teilmenge von B Bitpositionen zu finden (S504), die jeweils mit einem ersten kleinsten absoluten LLR-Wert in dem Satz von decodierten LLRs assoziiert sind, wobei B eine natürliche Zahl ist;
iii) anstelle des ersten kleinsten absoluten LLR-Wertes einen maximal möglichen absoluten LLR-Wert jeder Bitposition der ersten Teilmenge von B Bitpositionen zuzuweisen (S506); und
iv) erste $2^B$ Vektoren von LLRs auf der Grundlage des Satzes von demodulierten LLRs, des Satzes von decodierten LLRs und der ersten Teilmenge von B Bitpositionen zu bilden (S508);

wobei die Decodierungsvorrichtung veranlasst wird, in der ersten Zwischendecodierungsstufe:

v) jeden der ersten $2^B$ Vektoren von LLRs parallel zu decodieren (S602), wobei ein individueller Satz von decodierten LLRs für jeden der ersten $2^B$ Vektoren von LLRs erhalten wird;
vi) einen ersten gemittelten Satz von decodierten LLRs zu erhalten (S604), indem die individuellen Sätze von decodierten LLRs, die in Operation v) erhalten wurden, gemittelt werden;
vii) eine zweite Teilmenge von B Bitpositionen zu finden (S606), die jeweils mit einem zweiten kleinsten absoluten LLR-Wert in dem ersten gemittelten Satz von decodierten LLRs assoziiert sind, wobei die zweite Teilmenge von B Bitpositionen und die erste Teilmenge von B Bitpositionen nicht überlappend sind;
viii) anstelle des zweiten kleinsten absoluten LLR-Wertes den maximal möglichen absoluten LLR-Wert jeder Bitposition der zweiten Teilmenge von B Bitpositionen zuzuweisen (S608);
ix) zweite $2^B$ Vektoren von LLRs auf der Grundlage des Satzes von demodulierten LLRs, des ersten gemittelten Satzes von decodierten LLRs und der zweiten Teilmenge von B Bitpositionen zu bilden (S610);

wobei die Decodierungsvorrichtung veranlasst wird, in der zweiten Zwischendecodierungsstufe:

x) jeden der zweiten $2^B$ Vektoren von LLRs parallel zu decodieren (S702), wobei ein individueller Satz von decodierten LLRs für jeden der zweiten $2^B$ Vektoren von LLRs erhalten wird; und
xi) einen zweiten gemittelten Satz von decodierten LLRs zu erhalten (S704), indem die individuellen Sätze von decodierten LLRs, die in Operation x) erhalten wurden, gemittelt werden; und

wobei die Decodierungsvorrichtung veranlasst wird, in der Ausgangsdecodierungsstufe:
xii) den Satz von Bits auf der Grundlage des Satzes von demodulierten LLRs und des zweiten gemittelten Satzes von decodierten LLRs zu decodieren.

2. Decodierungsvorrichtung nach Anspruch 1, wobei der lineare fehlerkorrigierende Blockcode ein Low-Density-Parity-Check-Code (LDPC-Code) oder ein Polarcode ist und wobei der mehrstufige Decodierungsalgorithmus ein LDPC-Decodierungsalgorithmus bzw. ein Polarcode-Decodierungsalgorithmus ist.

3. Decodierungsvorrichtung nach Anspruch 2, wobei der LDPC-Decodierungsalgorithmus ein Min-Sum-LDPC-Decodierungsalgorithmus oder ein Sum-Product-LDPC-Decodierungsalgorithmus ist.

4. Decodierungsvorrichtung nach einem der Ansprüche 1 bis 3, wobei die Decodierungsvorrichtung ferner veranlasst wird, in Operation ix):
eine gewichtete Summe des Satzes von demodulierten LLRs und des ersten gemittelten Satzes von decodierten LLRs zu berechnen und die zweiten $2^B$ Vektoren von LLRs auf der Grundlage der gewichteten Summe des Satzes von demodulierten LLRs und des ersten gemittelten Satzes von decodierten LLRs zu bilden.

5. Decodierungsvorrichtung nach Anspruch 4, wobei der lineare fehlerkorrigierende Blockcode eine Blocklänge und eine Coderate aufweist und wobei die Decodierungsvorrichtung ferner veranlasst wird, die gewichtete Summe des Satzes von demodulierten LLRs und des ersten gemittelten Satzes von decodierten LLRs auf der Grundlage der Blocklänge und der Coderate zu berechnen.

6. Decodierungsvorrichtung nach einem der Ansprüche 1 bis 5, wobei die Decodierungsvorrichtung ferner veranlasst wird, in den Operationen i), vi) und x) zu prüfen, ob mindestens ein Bitfehler in dem Satz von decodierten LLRs, dem ersten gemittelten Satz von decodierten LLRs und dem zweiten gemittelten Satz von decodierten LLRs vorliegt, jeweils unter Verwendung einer Technik der zyklischen Redundanzprüfung (CRC).

7. Decodierungsverfahren in einem drahtlosen Kommunikationsnetz, umfassend:

Empfangen (S402) eines modulierten Signals, das einen Satz von Bits umfasst, der mit einem linearen fehlerkorrigierenden Blockcode codiert ist, wobei jedes Bit des Satzes von Bits eine Bitposition aufweist;
Erhalten (S404) eines Satzes von demodulierten Log-Likelihood-Verhältnissen, LLRs, für den Satz von Bits durch Demodulation des modulierten Signals; und
Decodieren (S406) des Satzes von Bits unter Verwendung eines mehrstufigen Decodierungsalgorithmus, der eine Eingangsdecodierungsstufe, eine erste Zwischendecodierungsstufe, eine zweite Zwischendecodierungsstufe und eine Ausgangsdecodierungsstufe umfasst;
wobei die Eingangsdecodierungsstufe umfasst:

i) Erhalten (S502) eines Satzes von decodierten LLRs auf der Grundlage des Satzes von demodulierten LLRs;
ii) Finden (S504) einer ersten Teilmenge von B Bitpositionen, die jeweils mit einem ersten kleinsten absoluten LLR-Wert in dem Satz von decodierten LLRs assoziiert sind, wobei B eine natürliche Zahl ist;
iii) anstelle des ersten kleinsten absoluten LLR-Wertes, Zuweisen (S506) eines maximal möglichen absoluten LLR-Wertes zu jeder Bitposition der ersten Teilmenge von B Bitpositionen; und
iv) Bilden (S508) von ersten $2^B$ Vektoren von LLRs auf der Grundlage des Satzes von demodulierten LLRs, des Satzes von decodierten LLRs und der ersten Teilmenge von B Bitpositionen;

wobei die erste Zwischendecodierungsstufe umfasst:

v) Decodieren (S602) jedes der ersten $2^B$ Vektoren von LLRs parallel, wobei ein individueller Satz von decodierten LLRs für jeden der ersten $2^B$ Vektoren von LLRs erhalten wird;
vi) Erhalten (S604) eines ersten gemittelten Satzes von decodierten LLRs durch Mitteln der individuellen Sätze von decodierten LLRs, die in Schritt v) erhalten wurden;
vii) Finden (S606) einer zweiten Teilmenge von B Bitpositionen, die jeweils mit einem zweiten kleinsten absoluten LLR-Wert in dem ersten gemittelten Satz von decodierten LLRs assoziiert sind, wobei die zweite Teilmenge von B Bitpositionen und die erste Teilmenge von B Bitpositionen nicht überlappend sind;
viii) anstelle des zweiten kleinsten absoluten LLR-Wertes, Zuweisen (S608) des maximal möglichen absoluten LLR-Wertes zu jeder Bitposition der zweiten Teilmenge von B Bitpositionen;
ix) Bilden (S610) von zweiten $2^B$ Vektoren von LLRs auf der Grundlage des Satzes von demodulierten LLRs, des ersten gemittelten Satzes von decodierten LLRs und der zweiten Teilmenge von B Bitpositionen;

wobei die zweite Zwischendecodierungsstufe umfasst:

x) Decodieren (S702) jedes der zweiten $2^B$ Vektoren von LLRs parallel, wobei ein individueller Satz von decodierten LLRs für jeden der zweiten $2^B$ Vektoren von LLRs erhalten wird; und
xi) Erhalten (S704) eines zweiten gemittelten Satzes von decodierten LLRs durch Mitteln der individuellen Sätze von decodierten LLRs, die in Schritt x) erhalten wurden; und

wobei die Ausgangsdecodierungsstufe umfasst:
xii) Decodieren des Satzes von Bits auf der Grundlage des Satzes von demodulierten LLRs und des zweiten gemittelten Satzes von decodierten LLRs.

8. Verfahren nach Anspruch 7, wobei der lineare fehlerkorrigierende Blockcode ein Low-Density-Parity-Check-Code (LDPC-Code) oder ein Polarcode ist und wobei der mehrstufige Decodierungsalgorithmus ein LDPC-Decodierungsalgorithmus bzw. ein Polarcode-Decodierungsalgorithmus ist.

9. Verfahren nach Anspruch 8, wobei der LDPC-Decodierungsalgorithmus ein Min-Sum-LDPC-Decodierungsalgorithmus oder ein Sum-Product-LDPC-Decodierungsalgorithmus ist.

10. Verfahren nach einem der Ansprüche 7 bis 9, wobei Schritt ix) durchgeführt wird, indem eine gewichtete Summe des Satzes von demodulierten LLRs und des ersten gemittelten Satzes von decodierten LLRs berechnet wird und die zweiten $2^B$ Vektoren von LLRs auf der Grundlage der gewichteten Summe des Satzes von demodulierten LLRs und des ersten gemittelten Satzes von decodierten LLRs gebildet werden.

11. Verfahren nach Anspruch 10, wobei der lineare fehlerkorrigierende Blockcode eine Blocklänge und eine Coderate aufweist und wobei die gewichtete Summe des Satzes von demodulierten LLRs und des ersten gemittelten Satzes von decodierten LLRs auf der Grundlage der Blocklänge und der Coderate berechnet wird.

12. Verfahren nach einem der Ansprüche 7 bis 11, ferner umfassend, in den Schritten i), vi) und x), Prüfen, ob mindestens ein Bitfehler in dem Satz von decodierten LLRs, dem ersten gemittelten Satz von decodierten LLRs und dem zweiten gemittelten Satz von decodierten LLRs vorliegt, jeweils unter Verwendung einer Technik der zyklischen Redundanzprüfung (CRC).

13. Computerlesbares Speichermedium, das ein Computerprogrammprodukt umfasst, wobei das computerlesbare Speichermedium Anweisungen speichert, die, wenn sie von mindestens einem Prozessor ausgeführt werden, den mindestens einen Prozessor veranlassen, das Verfahren nach einem der Ansprüche 7 bis 12 auszuführen.


**Revendications**

1. Appareil de décodage (300) dans un réseau de communication sans fil, comprenant :

   au moins un processeur (302) ; et
   au moins une mémoire (304) stockant des instructions (306) qui, lorsqu'elles sont exécutées par ledit au moins un processeur, amènent l'appareil de décodage à effectuer au moins les opérations suivantes :

   recevoir (S402) un signal modulé comprenant un jeu de bits codé avec un code en bloc correcteur d'erreurs linéaire, chaque bit du jeu de bits ayant une position de bit ;
   obtenir (S404) un jeu de rapports de log-vraisemblance démodulés, LLR, pour le jeu de bits par démodulation du signal modulé ; et
   décoder (S406) le jeu de bits en utilisant un algorithme de décodage multi-étages comprenant un étage de décodage d'entrée, un premier étage de décodage intermédiaire, un second étage de décodage intermédiaire et un étage de décodage de sortie ;

   dans lequel l'appareil de décodage est amené, à l'étage de décodage d'entrée, à :

   i) obtenir (S502) un jeu de LLR décodés sur la base du jeu de LLR démodulés ;
   ii) trouver (S504) un premier sous-ensemble de B positions de bits associées chacune à une première plus petite valeur absolue de LLR dans le jeu de LLR décodés, où B est un nombre naturel ;
   iii) au lieu de la première plus petite valeur absolue de LLR, assigner (S506) une valeur absolue de LLR maximale possible à chaque position de bit du premier sous-ensemble de B positions de bits ; et
   iv) former (S508) des premiers $2^B$ vecteurs de LLR sur la base du jeu de LLR démodulés, du jeu de LLR décodés et du premier sous-ensemble de B positions de bits ;

   dans lequel l'appareil de décodage est amené, au premier étage de décodage intermédiaire, à :

   v) décoder (S602) chacun des premiers $2^B$ vecteurs de LLR en parallèle, obtenant ainsi un jeu individuel de LLR décodés pour chacun des premiers $2^B$ vecteurs de LLR ;
   vi) obtenir (S604) un premier jeu moyenné de LLR décodés en moyennant les jeux individuels de LLR décodés obtenus à l'opération v) ;
   vii) trouver (S606) un second sous-ensemble de B positions de bits associées chacune à une seconde plus petite valeur absolue de LLR dans le premier jeu moyenné de LLR décodés, le second sous-ensemble de B positions de bits et le premier sous-ensemble de B positions de bits étant non chevauchants ;
   viii) au lieu de la seconde plus petite valeur absolue de LLR, assigner (S608) la valeur absolue de LLR maximale possible à chaque position de bit du second sous-ensemble de B positions de bits ;
   ix) former (S610) des seconds $2^B$ vecteurs de LLR sur la base du jeu de LLR démodulés, du premier jeu moyenné de LLR décodés et du second sous-ensemble de B positions de bits ;

   dans lequel l'appareil de décodage est amené, au second étage de décodage intermédiaire, à :

   x) décoder (S702) chacun des seconds $2^B$ vecteurs de LLR en parallèle, obtenant ainsi un jeu individuel de LLR décodés pour chacun des seconds $2^B$ vecteurs de LLR ; et
   xi) obtenir (S704) un second jeu moyenné de LLR décodés en moyennant les jeux individuels de LLR décodés obtenus à l'opération x) ; et

dans lequel l'appareil de décodage est amené, à l'étage de décodage de sortie, à :

xii) décoder le jeu de bits sur la base du jeu de LLR démodulés et du second jeu moyenné de LLR décodés.

2. Appareil de décodage selon la revendication 1, dans lequel le code en bloc correcteur d'erreurs linéaire est un code de contrôle de parité à faible densité (LDPC) ou un code polaire, et dans lequel l'algorithme de décodage multi-étages est un algorithme de décodage LDPC ou un algorithme de décodage de code polaire, respectivement.

3. Appareil de décodage selon la revendication 2, dans lequel l'algorithme de décodage LDPC est un algorithme de décodage LDPC de type somme minimale ou un algorithme de décodage LDPC de type somme-produit.

4. Appareil de décodage selon l'une quelconque des revendications 1 à 3, dans lequel l'appareil de décodage est en outre amené, à l'opération ix), à :
calculer une somme pondérée du jeu de LLR démodulés et du premier jeu moyenné de LLR décodés, et à former les seconds $2^B$ vecteurs de LLR sur la base de la somme pondérée du jeu de LLR démodulés et du premier jeu moyenné de LLR décodés.

5. Appareil de décodage selon la revendication 4, dans lequel le code en bloc correcteur d'erreurs linéaire a une longueur de bloc et un taux de codage, et dans lequel l'appareil de décodage est en outre amené à calculer la somme pondérée du jeu de LLR démodulés et du premier jeu moyenné de LLR décodés sur la base de la longueur de bloc et du taux de codage.

6. Appareil de décodage selon l'une quelconque des revendications 1 à 5, dans lequel l'appareil de décodage est en outre amené, aux opérations i), vi) et x), à vérifier s'il y a au moins une erreur de bit dans le jeu de LLR décodés, le premier jeu moyenné de LLR décodés et le second jeu moyenné de LLR décodés, respectivement, en utilisant une technique de contrôle de redondance cyclique (CRC).

7. Procédé de décodage dans un réseau de communication sans fil, comprenant :

recevoir (S402) un signal modulé comprenant un jeu de bits codé avec un code en bloc correcteur d'erreurs linéaire, chaque bit du jeu de bits ayant une position de bit ;
obtenir (S404) un jeu de rapports de log-vraisemblance démodulés, LLR, pour le jeu de bits par démodulation du signal modulé ; et
décoder (S406) le jeu de bits en utilisant un algorithme de décodage multi-étages comprenant un étage de décodage d'entrée, un premier étage de décodage intermédiaire, un second étage de décodage intermédiaire et un étage de décodage de sortie ;
dans lequel l'étage de décodage d'entrée comprend :

i) obtenir (S502) un jeu de LLR décodés sur la base du jeu de LLR démodulés ;
ii) trouver (S504) un premier sous-ensemble de B positions de bits associées chacune à une première plus petite valeur absolue de LLR dans le jeu de LLR décodés, où B est un nombre naturel ;
iii) au lieu de la première plus petite valeur absolue de LLR, assigner (S506) une valeur absolue de LLR maximale possible à chaque position de bit du premier sous-ensemble de B positions de bits ; et
iv) former (S508) des premiers $2^B$ vecteurs de LLR sur la base du jeu de LLR démodulés, du jeu de LLR décodés et du premier sous-ensemble de B positions de bits ;

dans lequel le premier étage de décodage intermédiaire comprend :

v) décoder (S602) chacun des premiers $2^B$ vecteurs de LLR en parallèle, obtenant ainsi un jeu individuel de LLR décodés pour chacun des premiers $2^B$ vecteurs de LLR ;
vi) obtenir (S604) un premier jeu moyenné de LLR décodés en moyennant les jeux individuels de LLR décodés obtenus à l'étape v) ;
vii) trouver (S606) un second sous-ensemble de B positions de bits associées chacune à une seconde plus petite valeur absolue de LLR dans le premier jeu moyenné de LLR décodés, le second sous-ensemble de B positions de bits et le premier sous-ensemble de B positions de bits étant non chevauchants ;
viii) au lieu de la seconde plus petite valeur absolue de LLR, assigner (S608) la valeur absolue de LLR maximale possible à chaque position de bit du second sous-ensemble de B positions de bits ;
ix) former (S610) des seconds $2^B$ vecteurs de LLR sur la base du jeu de LLR démodulés, du premier jeu moyenné de LLR décodés et du second sous-ensemble de B positions de bits ;

dans lequel le second étage de décodage intermédiaire comprend :

x) décoder (S702) chacun des seconds $2^B$ vecteurs de LLR en parallèle, obtenant ainsi un jeu individuel de LLR décodés pour chacun des seconds $2^B$ vecteurs de LLR ; et
xi) obtenir (S704) un second jeu moyenné de LLR décodés en moyennant les jeux individuels de LLR décodés obtenus à l'étape x) ; et

dans lequel l'étage de décodage de sortie comprend :
xii) décoder le jeu de bits sur la base du jeu de LLR démodulés et du second jeu moyenné de LLR décodés.

**8.** Procédé selon la revendication 7, dans lequel le code en bloc correcteur d'erreurs linéaire est un code de contrôle de parité à faible densité (LDPC) ou un code polaire, et dans lequel l'algorithme de décodage multi-étages est un algorithme de décodage LDPC ou un algorithme de décodage de code polaire, respectivement.

**9.** Procédé selon la revendication 8, dans lequel l'algorithme de décodage LDPC est un algorithme de décodage LDPC de type somme minimale ou un algorithme de décodage LDPC de type somme-produit.

**10.** Procédé selon l'une quelconque des revendications 7 à 9, dans lequel l'étape ix) est effectuée en calculant une somme pondérée du jeu de LLR démodulés et du premier jeu moyenné de LLR décodés et en formant les seconds $2^B$ vecteurs de LLR sur la base de la somme pondérée du jeu de LLR démodulés et du premier jeu moyenné de LLR décodés.

**11.** Procédé selon la revendication 10, dans lequel le code en bloc correcteur d'erreurs linéaire a une longueur de bloc et un taux de codage, et dans lequel la somme pondérée du jeu de LLR démodulés et du premier jeu moyenné de LLR décodés est calculée sur la base de la longueur de bloc et du taux de codage.

**12.** Procédé selon l'une quelconque des revendications 7 à 11, comprenant en outre, aux étapes i), vi) et x), de vérifier s'il y a au moins une erreur de bit dans le jeu de LLR décodés, le premier jeu moyenné de LLR décodés et le second jeu moyenné de LLR décodés, respectivement, en utilisant une technique de contrôle de redondance cyclique (CRC).

**13.** Support de stockage lisible par ordinateur comprenant un produit de programme informatique, dans lequel le support de stockage lisible par ordinateur stocke des instructions qui, lorsqu'elles sont exécutées par au moins un processeur, amènent ledit au moins un processeur à effectuer le procédé selon l'une quelconque des revendications 7 à 12.

**FIG. 1**

**FIG. 2A**

**FIG. 2B**

**FIG. 2C**

**FIG. 2D**

300

304

306

Instructions

Memory

302

Processor

Decoding apparatus

**FIG. 3**

**EP 4 550 671 B1**

400

**S402** — Receiving a modulated signal comprising a set of bits encoded with a linear error-correcting block code, each bit of the set of bits having a bit position

**S404** — Obtaining a set of demodulated LLRs for the set of bits by demodulating the modulated signal

**S406** — Decoding the set of bits by using a multi-stage decoding algorithm based on the set of demodulated LLRs, the multi-stage decoding algorithm comprising an input decoding stage, a first intermediate decoding stage, a second intermediate decoding stage and an output decoding stage

**FIG. 4**

23

$500$

S502

> Obtaining a set of decoded LLRs based on a set of demodulated LLRs

S504

> Finding a first subset of $B$ bit positions each associated with a first smallest absolute LLR value in the set of decoded LLRs

S506

> Assigning a maximum possible absolute LLR value to each bit position of the first subset of $B$ bit positions

S508

> Forming first $2^B$ vectors of LLRs based on the set of demodulated LLRs, the set of decoded LLRs, and the first subset of $B$ bit positions

**FIG. 5**

S602 — Decoding each of the first $2^B$ vectors of LLRs in parallel, thereby obtaining an individual set of decoded LLRs for each of the first $2^B$ vectors of LLRs

600

S604 — Obtaining a first averaged set of decoded LLRs by averaging the individual sets of decoded LLRs obtained in sub-step S602

S606 — Finding a second subset of $B$ bit positions each associated with a second smallest absolute LLR value in the first averaged set of decoded LLRs

S608 — Assigning the maximum possible absolute LLR value to each bit position of the second subset of $B$ bit positions

S610 — Forming second $2^B$ vectors of LLRs based on the set of demodulated LLRs, the first averaged set of decoded LLRs and the second subset of $B$ bit positions

**FIG. 6**

700

S702

Decoding each of the second $2^B$ vectors of LLRs
in parallel, thereby obtaining an individual set of decoded
LLRs for each of the second $2^B$ input vectors

S704

Obtaining a second averaged set of decoded LLRs by
averaging the individual sets of decoded LLRs obtained in
sub-step S702

**FIG. 7**

FIG. 8

**FIG. 9A**

**FIG. 9B**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2020088256 A1

### Non-patent literature cited in the description

- **S. SCHOLL et al.** Advanced iterative channel coding schemes: When Shannon meets Moore. *IEEE 9th International Symposium on Turbo Codes and Iterative Information Processing, ISTC 2016*, 05 September 2016, 406-411
- **V. NEDELJKO et al.** Augmented Belief Propagation Decoding of Low-Density Parity Check Codes. *IEEE Trans. Communications*, 01 July 2007, vol. 55 (7), ISSN 0090-6778, 1308-1317

- **SAMSUNG**. Quasi-ML Decoding of Short Length LDPC Codes. *3GPP Draft; R1-1612551_Quasi-ML Decoding of Short Length LDPC Codes_final, RAN WG1*, 05 November 2016, 20161114-20161118, http://www.3gpp.org/ftp/tsg_ran/WG1_RL1/TSGR1_87/Docs
- A new LDPC decoder hardware implementation with improved error rates. **P. SCHLAEFER** ; **S. SCHOLL** ; **E. LEONARDI** ; **N. WEHN**. 2015 IEEE Jordan Conference on Applied Electrical Engineering and Computing Technologies (AEECT). 2015, 1-6